# EUROPEAN PATENT SPECIFICATION

(11) **EP 1 026 707 B1**
(45) Date of publication and mention of the grant of the patent: **02.10.2002**
(21) Application number: 00100859.8
(22) Date of filing: 18.01.2000
(51) Int. Cl.: H01F 27/02, H01F 27/29

(54) **Wire wound inductor**
Drahtgewickelte Induktivität
Bobine d'inductance

(30) Priority: 03.02.1999 GB 9902288
(43) Date of publication of application: 09.08.2000
(73) Proprietor: Pace Micro Technology PLC, Shipley, West Yorkshire BD18 3LF (GB)
(72) Inventor: Jenkins, Steven, Huddersfield, HD4 5RS (GB)
(74) Representative: Wood, Graham

(56) References cited:
- WO-A-90/13135
- WO-A-96/19814
- DE-A- 3 615 307
- DE-B- 1 273 630
- DE-U- 9 410 532
- PATENT ABSTRACTS OF JAPAN vol. 006, no. 194 (E-134), 2 October 1982 (1982-10-02) & JP 57 106015 A (MATSUSHITA ELECTRIC WORKS LTD), 1 July 1982 (1982-07-01)

## Description

The invention of this application relates to an improvement to a wire wound inductor of the type typically used as a component of many electrical and electronic apparatus such as, for example, set top box broadcast data receivers.

Currently, in order to allow machine placing of inductor components the wire of the inductor is formed around ceramic blocks. These ceramic blocks can adversely affect the inductor characteristics but if the ceramic block is not used the wire wound inductor needs to be hand fitted which is time consuming and expensive.

Inductor components are used in many instances and are typically fitted to a printed circuit board in conjunction with a number of other components as part of an assembly process which involves the assembly and placing and joining of a series of components in a required configuration to form a control and operating systems for an item of electrical apparatus. Conventionally the assembly of components to form this type of apparatus is highly automated and is required due to the relatively small size of the components and the speed of assembly required and the high volume of components on the board. The ability to automate the process is increased due to the relatively uniform size of the components which makes the use of automated and robotic pick and place machines relatively easy as the size and positioning of the components can be accurately easily determined and controlled. However, it is found that if inductors are used where the wire is not wound around ceramic blocks the same cannot easily be picked up by a pick and place machine as the inductors are relatively large and are formed of a wire which is wound into a coil with the wire being of circular cross section and so it is extremely difficult to pick up a wire wound inductor by the suction mechanism of a pick and place machine. Furthermore, it is difficult, even when the inductor is positioned in the required position for joining to the board, for the same to be held in the required position during the joining process, which is typically by soldering, and therefore the use of inductors, although necessary, is problematic.

From document WO-A-96/19814 there is known a wire wound inductor according to the preamble of claim 1.

The aim of the present invention is to provide an inductor in an improved form to allow the same to be more easily picked and placed and joined to a board in the required position than is conventionally the case.

This is solved by having the location portions depend inwardly of the inductor to lie in substantially the same plane on the surface on which the inductor is located.

In one embodiment all of the surface of the wire which faces externally of the inductor is provided to have a flat form. Preferably the said external surface has no visible protrusions and is planar in form.

In use therefore, when wire of this form is used the external surface of the inductor is relatively flat and therefore relatively smooth which improves the ability for the same to be picked up by a suction mechanism of a pick and place machine.

In one preferred embodiment, the wire used for the inductor is formed of strip material and, when wound, a relatively flat first surface faces externally of the inductor and an opposing flat surface faces internally of the inductor.

The wire can be wound about an axis as many times as required depending on the inductance value required or alternatively the diameter of the winding can be altered to determine the inductance value required.

In one embodiment, a preferred material cross section is for the external and internal flat surfaces to be 1mm in width and for the depth of the material between said surfaces to be 0.2mm but it shall be appreciated that these are example dimensions only and are not intended to restrict the application in any way.

In a further feature of the invention the inductor is formed so that successive windings of the wire are formed with a flattened portion in the same respective position to form in combination a flattened portion which improves the ability for the same to be picked up by suction means. Typically the area of the flattened portion formed by the combination of windings is the same or greater than the suction head used with the pick and place apparatus.

In a further feature of the invention the surface onto which the inductor is located is a surface of a printed circuit board and the inductor portions are soldered and/or otherwise joined to the board. Typically, the portions are of a dimension to suit specific fixing and locating requirements.

The wire wound inductor can include on the wire used to form the same first, relatively flat location portions to allow the inductor to be picked and placed in position by automated apparatus and the same portions or second relatively flat portions can be provided to provide improved location and support of the inductor on the surface to which the same is to be joined.

Specific embodiments of the invention will now be described with reference to the accompanying drawing wherein:-
Figure 1 illustrates an isometric diagram of an inductor according to one embodiment of the invention; and
Figure 2 illustrates an elevation of the inductor of Figure 1.

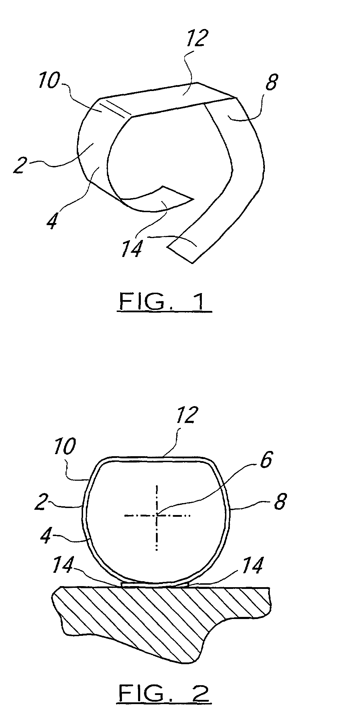

Referring to the figures 1 and 2 they show an inductor 2 formed of a strip of material 4 wound around a central axis 6 to form a coil. It will be seen that the wire 4 used is in the form of a strip so that it has an internal flat surface 8 and an external flat surface 10. In the form shown, the coil is also provided with a flattened portion 12 which in this case is formed from one winding of the strip but may in certain instances be formed from a series of windings all provided with a flattened area. The provision of the flattened portion 12 is to act as location means to allow suction means, not shown, of a pick and place machine to obtain a secure fitting on the portion which is sufficient to allow the coil to be picked up, moved and placed in position on a board in combination with other components to form the electrical apparatus.

In order to allow the inductor to be securely positioned on the board for soldering to join the same to a printed circuit board( not shown), the inductor coil in this embodiment is provided with further location means in the form of portions 14 at each end of the wire and these portions are formed and provided so that the same lie in substantially the same plane so that when the same are positioned on the board both portions contact with the board and acts as location portions to support the inductor in the required position during soldering.

Thus, the inductor formed according to the present invention will be of benefit both in the efficiency of picking and placing the same in position for joining using automated apparatus and during the joining process itself. This allows fast assembly, consistent placement and overcomes the need for any hand cropping or cutting of the component to fit and overcomes the need to use ceramic blocks. It also ensures that the existing advantages of wire wound inductors are maintained in terms of cost effectiveness and high performance which is typical of this type of through-hole wire wound air core conductors

The inductor of the invention also has further advantages over current inductors in that it decreases the dynamic range of the tuning voltage required to achieve full frequency range of certain modulators such as the Philips TDA 8822 and can also be used to reduce the adverse temperature effects which are associated with inductor "Q" factor such as with the Motorola MC4435 modulator. This is achieved as the invention enables the automatic placing of the wire wound inductor without the need for the ceramic block insert and thereby improves the inductor Q value in comparison with the conventional inductors.

## Claims

1. A wire wound inductor (2) for use as an electrical component of electrical or electronic apparatus, wherein said inductor is formed from a length of wire (4) which is wound about an axis (6) a required number of times and the end portions (14) of the wire act as location portions for the inductor on a surface, and the surfaces of the portions (14) facing externally of the inductor are relatively flat and **characterised in that** the location portions (14) depend inwardly of the inductor to lie in substantially the same plane on the surface on which the inductor is located.

2. A wire wound inductor according to claim 1 **characterised in that** the wire used for the inductor is formed of strip material and, when wound, a relatively flat first surface faces externally of the inductor and an opposing flat surface faces internally of the inductor.

3. A wire wound inductor according to claim 2 **characterised in that** the external and internal flat surfaces are 1mm in width and the depth of the material between said surfaces is 0.2mm.

4. A wire wound inductor according to claim 1 **characterised in that** when wound, successive windings of the wire are provided with a relatively flat portion in the same respective position to form a location portion (12) for inductor handling apparatus.

5. A wire wound inductor according to claim 1 **characterised in that** the surface onto which the inductor is located is a surface of a printed circuit board and the inductor portions (14) are soldered and/or otherwise joined to the board.

6. A wire wound inductor according to claim 1 **characterised in that** the required inductance value of the inductor is achieved by winding the wire about the axis (6) as many times as required and defining the diameter of the winding.

## Patentansprüche

1. Drahtgewickelter Induktor (2) für die Verwendung als elektrische Komponente von elektrischen und elektronischen Geräten, wobei der genannte Induktor aus einem Stück Draht (4) gebildet ist, der so oft wie nötig um eine Achse (6) gewickelt wird, und wobei die Endabschnitte (14) des Drahtes als Positionsgabeabschnitte für den Induktor auf einer Oberfläche wirken, und wobei die Oberflächen der vom Induktor nach außen zeigenden Abschnitte (14) relativ flach sind, und **dadurch gekennzeichnet, dass** die Positionsgabeabschnitte (14) vom Induktor nach innen hängen und im Wesentlichen in derselben Ebene auf der Oberfläche liegen, auf der sich der Induktor befindet.

2. Drahtgewickelter Induktor nach Anspruch 1, **dadurch gekennzeichnet, dass** der für den Induktor verwendete Draht aus einem Bandmaterial gebildet ist und dass beim Wickeln eine relativ flache erste Oberfläche vom Induktor nach außen und eine gegenüberliegende flache Oberfläche vom Induktor nach innen zeigt.

3. Drahtgewickelter Induktor nach Anspruch 1, **dadurch gekennzeichnet, dass** die flachen Außen- und Innenflächen eine Breite von lmm haben und die Tiefe des Materials zwischen den genannten Flächen 0,2 mm beträgt.

4. Drahtgewickelter Induktor nach Anspruch 1, **dadurch gekennzeichnet, dass** beim Wickeln aufeinander folgende Wicklungen des Drahtes mit einem relativ flachen Abschnitt in derselben jeweiligen Position vorgesehen sind, um einen Positionsgabeabschnitt (12) für die Induktorhandhabungsvorrichtung zu bilden.

5. Drahtgewickelter Induktor nach Anspruch 1, **dadurch gekennzeichnet, dass** die Oberfläche, auf die der Induktor gelegt wird, eine Oberfläche einer Leiterplatte ist und die Induktorabschnitte (14) mit der Leiterplatte verlötet und/oder auf andere Weise damit verbunden werden.

6. Drahtgewickelter Induktor nach Anspruch 1, **dadurch gekennzeichnet, dass** der benötigte Induktanzwert des Induktors durch Wickeln des Drahtes so oft wie nötig um die Achse (6) und durch Definieren des Durchmessers der Wicklung erzielt wird.

## Revendications

1. Bobine d'inductance (2) destinée à être utilisée comme composant électrique dans un appareil électrique ou électronique, dans laquelle ledit inducteur est formé à partir d'une longueur de fil (4) qui est enroulé autour d'un axe (6) un certain nombre de fois et les sections d'extrémité (14) du fil jouent le rôle de sections de repérage pour l'inducteur sur une surface, tandis que les surfaces des sections (14) dirigées vers l'extérieur de l'inducteur sont relativement plates et **caractérisée en ce que** les sections de repérage (14) sont inclinées vers l'intérieur de l'inducteur pour qu'elles se trouvent essentiellement dans le même plan que la surface sur laquelle l'inducteur est positionné.

2. Bobine d'inductance, selon la revendication 1, **caractérisée en ce que** le fil utilisé pour l'inducteur est formé à partir de matériau en feuillard et, lorsqu'il est bobiné, une première surface relativement plate est dirigée vers l'extérieur de l'inducteur, et une surface plate opposée est dirigée vers l'intérieur de l'inducteur.

3. Bobine d'inductance, selon la revendication 2, **caractérisée en ce que** les surfaces plates externes et internes ont une largeur de 1 mm, et la profondeur du matériau entre lesdites surfaces est égale à 0,2 mm.

4. Bobine d'inductance, selon la revendication 1, **caractérisée en ce que**, lorsqu'ils sont bobinés, les enroulements successifs du fil disposent d'une section relativement plate dans la même position respective afin de constituer une section de repérage (12) pour l'appareil de manipulation de l'inducteur.

5. Bobine d'inductance, selon la revendication 1, **caractérisée en ce que** la surface sur laquelle l'inducteur est implanté est une surface de carte à circuits imprimés et les sections de l'inducteur (14) sont brasées et/ou liaisonnées par un autre moyen sur la carte.

6. Bobine d'inductance, selon la revendication 1, **caractérisée en ce que**, pour obtenir la valeur d'inductance requise pour l'inducteur, le fil est enroulé autour de l'axe (6) autant de fois que cela est nécessaire, et définit le diamètre du bobinage.
